# EUROPEAN PATENT SPECIFICATION

(11) **EP 3 241 644 B1**
(45) Date of publication and mention of the grant of the patent: **19.10.2022**
(21) Application number: 15881136.4
(22) Date of filing: 21.04.2015
(51) Int. Cl.: G01N 3/40, G01N 3/32, B24C 1/10, C21D 7/06, B23P 9/04

(54) **RESIDUAL STRESS EVALUATION METHOD**
VERFAHREN ZUR RESTSPANNUNGSBEURTEILUNG
PROCÉDÉ D'ÉVALUATION DE CONTRAINTE RÉSIDUELLE

(30) Priority: 05.02.2015 JP 2015021571
(43) Date of publication of application: 08.11.2017
(73) Proprietor: Mitsubishi Heavy Industries, Ltd., Tokyo 108-8215 (JP)
(72) Inventor: OGAWA, Naoki, Tokyo 108-8215 (JP); OCHI, Mayumi, Tokyo 108-8215 (JP); HORI, Nobuyuki, Tokyo 108-8215 (JP)
(74) Representative: Cabinet Beau de Loménie
(86) International application number: PCT/JP2015/062096
(87) International publication number: WO 2016/125319

(56) References cited:
- WO-A2-2014/002917
- JP-A- 2008 155 345
- JP-A- 2011 033 582
- JP-A- 2015 104 775
- JP-B2- 5 011 416
- US-A1- 2003 225 476
- US-A1- 2011 232 348
- Masashi Fukaya: "Prediction of Cavitation Erosion and Residual Stress of Material Using Cavitating Flow Simulation with Bubble Flow Model" In: "Advanced Experimental and Numerical Techniques for Cavitation Erosion Prediction", 1 January 2014 (2014-01-01), Springer Netherlands, Dordrecht, XP055437268, ISSN: 0926-5112 ISBN: 978-94-017-8539-6 vol. 106, pages 303-327, DOI: 10.1007/978-94-017-8539-6_13, * Eq: 13.18 & 13.21 *
- N. RAJESH ET AL: "Multidroplet Impact Model for Prediction of Residual Stresses in Water Jet Peening of Materials", MATERIALS AND MANUFACTURING PROCESSES, vol. 21, no. 4, 1 July 2006 (2006-07-01), pages 399-409, XP055205589, ISSN: 1042-6914, DOI: 10.1080/10426910500411736
- MASASHI FUKAYA ET AL.: 'Development of Water Jet Peening (3) : Evaluation of Flow Behavior on WJP' THE JAPAN SOCIETY OF MECHANICAL ENGINEERS, M&M ZAIRYO RIKIGAKU CONFERENCE July 2009, pages 333 - 334, XP008185791
- HITOSHI SOYAMA: 'Surface modification of light metallic materials by using cavitation shotless peening' JOURNAL OF JAPAN INSTITUTE OF LIGHT METALS vol. 56, no. 1, 2006, pages 56 - 62, XP055401179

## Description

### TECHNICAL FIELD

The present disclosure relates to a method of evaluating a residual stress improved by water jet peening, a program for performing the method, and an apparatus for performing the method.

### BACKGROUND ART

Stress corrosion cracking (SCC) is one of degradation phenomena of components (e.g. metal) that occurs in high-temperature water. If SCC is caused by tensile residual stress generated at a welding section or the like, the degradation could be prevented by applying water jet peening (hereinafter, referred to as WJP) to the component. WJP is a technique whereby the residual stress in the vicinity of the surface of the component (target) can be improved, and which can be performed under water. More specifically, in WJP, highpressure water is injected from a nozzle to the surface of a target to produce bubbles (cavitation bubbles), and the impact pressure generated at the collapse of the cavitation bubbles is made use of to create plastic deformation on the surface of the target. Through such plastic deformation, the residual pressure in the vicinity of the surface of the target is reduced, or the tensile residual stress in the vicinity of the surface thereof is improved to a compressive residual stress, and thereby SCC is suppressed.

Furthermore, some techniques have been proposed to evaluate the residual pressure of components after WJP. For instance, Patent Document 1 discloses a method of predicting the residual stress of a processed section. Specifically, in Patent Document 1, in light of the knowledge that the collapse pressure of cavitation bubbles can be obtained on the basis of a correlation between the residual stress after WJP and the collapse pressure of cavitation bubbles and cavitation energy applied to the surface of a WJP processing target, cavitation energy is calculated from the bubble inner pressure and the bubble density of cavitation bubbles obtained by analyzing a jet flow injected from the nozzle, the collapse pressure of cavitation bubbles is calculated on the basis of the cavitation energy, and the collapse pressure is used to calculate the residual stress of the surface of the processing target after WJP.

### Citation List

### Patent Literature

Patent Document 1: JP5011416B

### SUMMARY

### Problems to be Solved

As described above, in Patent Document 1, the collapse pressure of cavitation bubbles is obtained on the basis of an analysis result of cavitation energy (bubble internal pressure and bubble density of cavitation bubbles). In contrast, the present disclosure focused on the generation/disappearance state of cavitation bubbles during WJP, and discovered that it is possible to predict a distribution of the actual impact pressure generated by cavitation bubbles (impact pressure at each position on the surface of a processing target) by obtaining a correlation value correlated to the actual impact pressure generated by cavitation bubbles by analysis, and associating the analyzed correlation value with an experimental value. The residual stress after WJP is evaluated from the predicted value of the impact pressure.

In view of the above, an object of at least one embodiment of the present invention is to provide a method of evaluating a residual stress on the basis of analysis on the generation/disappearance state of cavitation bubbles during water jet peening (WJP). Solution to the Problems

The invention is defined by the appended claims.
(1) A method of evaluating a residual stress is defined in claim 1.

With the above configuration (1), the generation/disappearance state of cavitation bubbles during water jet peening (WJP) is analyzed, and thereby it is possible to predict the actual distribution of impact pressure (impact pressure at each position on the surface of a processing target) of WJP generated in the vicinity of the surface of the processing target, and to evaluate the residual stress after WJP on the basis of the predicted impact pressure. With the above configuration (1), it is possible to associate the impact pressure experimental value with the impact pressure correlation value at each position on the surface of a processing target model by determining the above described coefficient k, and thereby it is possible to analyze/evaluate the actual residual stress after water jet peening (WJP) in the vicinity of the surface of a processing target.

(2) In some embodiments, in any one of the above configuration (1),the method further comprises: a target setting step of setting a target value of the residual stress; a processing-condition changing step of changing the processing condition if the residual stress does not satisfy the target value; a re-evaluation step of executing the analysis step, the impact pressure correlation value calculation step, and the residual-stress evaluation step under a changed processing condition changed in the processing-condition changing step; and a processing-condition determination step of determining the processing condition used in the re-evaluation step as the processing condition for the processing target, if the residual stress calculated in the re-evaluation step satisfies the target value. With the above configuration (2), a processing condition satisfying the target value is determined on the basis of comparison between a target value of residual stress and an analysis value of residual stress after water jet peening (WJP) under a processing condition. Thus, even in a case where WJP is to be performed under an unproven processing condition to suit for the specification of a plant, it is possible to evaluate the residual stress after WJP through analysis, and to determine a suitable processing condition for the specification of the plant. Furthermore, WJP can be performed reliably by actually performing WJP under a processing condition determined as described above. Moreover, it is possible to make use of the analysis in design of a WJP processing apparatus capable of performing WJP under desired processing conditions.

(3) In some embodiments, in the above configuration (2), if the residual stress calculated in the re-evaluation step does not satisfy the target value, the processing condition is further changed in the processing-condition changing step, and the re-evaluation step is performed under the changed processing condition further changed in the processing-condition changing step. With the above configuration (3) , if the evaluation result of residual stress after water jet peening under a processing condition does not satisfy the target value, a similar evaluation is performed under another processing condition. Accordingly, it is possible to determine a processing condition that satisfies the target value.

(4) In some embodiments, in any one of the above configurations (1) to (3), the processing condition includes at least one of: an injection time of water jet by the water jet peening; an injection speed of the water jet, a flow rate of the water jet, a processing range of the water jet peening, an injection distance of the water jet, a radius of the bubbles, a nozzle angle, or an inclination angle of the surface of the processing target.

With the above configuration (4), various conditions that may affect the residual stress after WJP are included in the processing condition, and thus it is possible to evaluate the residual stress after WJP under a processing condition accurately.

(5) An evaluation program for water jet peening is defined in claim 5.

With the above configuration (5), , the generation/disappearance state of cavitation bubbles during water jet peening (WJP) is analyzed, and thereby it is possible to predict the actual distribution of impact pressure (impact pressure at each position on the surface of a processing target) of WJP generated in the vicinity of the surface of the processing target, and to evaluate the residual stress after WJP on the basis of the predicted impact pressure.

(6) An evaluation apparatus for water jet peening is defined in claim 6.

### Advantageous Effects

According to at least one embodiment of the present invention, provided is a method of evaluating a residual stress on the basis of analysis on the generation/disappearance state of cavitation bubbles during water jet peening (WJP).

### BRIEF DESCRIPTION OF DRAWINGS

FIG. 1 is a schematic configuration diagram of a WJP evaluation apparatus according to an embodiment of the present invention.
FIG. 2 is a flowchart of a procedure of a method of evaluating WJP according to an embodiment of the present invention.
FIG. 3 is a diagram for describing a relationship between the surface of a processing target and an injection nozzle according to an embodiment of the present invention.
FIG. 4 is a diagram of an injection nozzle according to an embodiment of the present invention.
FIG. 5 is a diagram for describing a relationship between an impact pressure correlation value Pc, an impact pressure experimental value Pr, and an impact pressure predicted value Pp, corresponding to FIG. 3.
FIG. 6A is a diagram for describing an example of a pressure distribution of the impact pressure due to WJP, corresponding to FIG. 3.
FIG. 6B is a diagram for describing another example of a pressure distribution of the impact pressure due to WJP.
FIG. 7A is a diagram for describing an exemplary specification of a plant.
FIG. 7B is a diagram for describing another exemplary specification of a plant.
FIG. 8 is a schematic configuration diagram of a WJP evaluation apparatus according to another embodiment of the present invention.
FIG. 9 is a flowchart of a procedure of a method of evaluating WJP according to another embodiment of the present invention.

### DETAILED DESCRIPTION

Embodiments of the present invention will now be described in detail with reference to the accompanying drawings. It is intended, however, that unless particularly specified, dimensions, materials, shapes, relative positions and the like of components described in the embodiments shall be interpreted as illustrative only and not intended to limit the scope of the present invention.

For instance, an expression of relative or absolute arrangement such as "in a direction", "along a direction", "parallel", "orthogonal", "centered", "concentric" and "coaxial" shall not be construed as indicating only the arrangement in a strict literal sense, but also includes a state where the arrangement is relatively displaced by a tolerance, or by an angle or a distance whereby it is possible to achieve the same function.

For instance, an expression of an equal state such as "same" "equal" and "uniform" shall not be construed as indicating only the state in which the feature is strictly equal, but also includes a state in which there is a tolerance or a difference that can still achieve the same function.

Further, for instance, an expression of a shape such as a rectangular shape or a cylindrical shape shall not be construed as only the geometrically strict shape, but also includes a shape with unevenness or chamfered corners within the range in which the same effect can be achieved.

On the other hand, an expression such as "comprise", "include", "have", "contain" and "constitute" are not intended to be exclusive of other components.

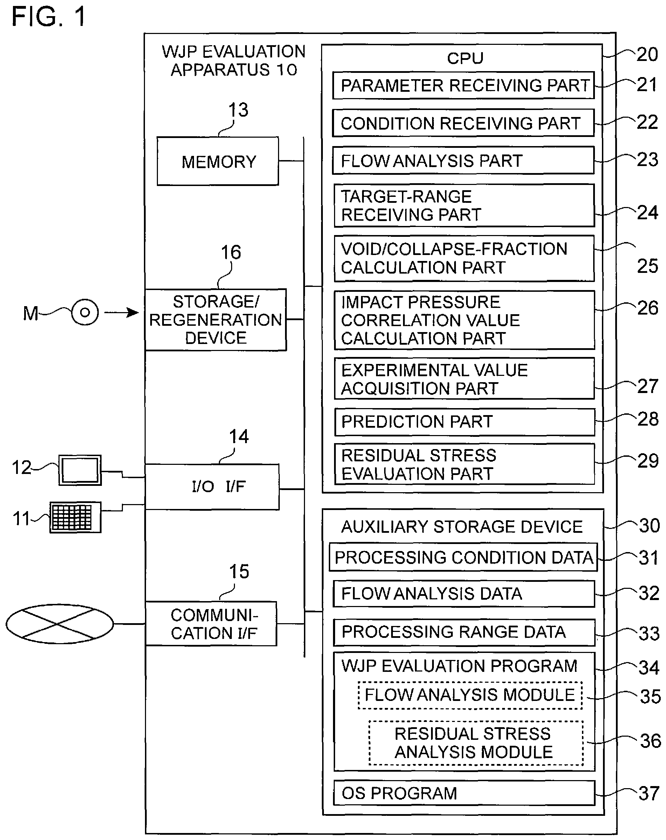

FIG. 1 is a functional block diagram of an evaluation apparatus 10 of water jet peening (WJP) (hereinafter, WJP evaluation apparatus 10) for evaluating the residual stress after WJP according to an embodiment of the present invention.

The WJP evaluation apparatus 10 is an apparatus capable of evaluating in advance the actual residual pressure (result of WJP) in the vicinity of the surface of a component such as metal (processing target 40) after WJP, before performing WJP on the processing target 40. The WJP evaluation apparatus 10 may be a computer including a WJP evaluation program 34, as in the embodiment shown in FIG. 1. Hereinafter, the WJP evaluation apparatus 10 will be described as a computer including the WJP evaluation program 34.

In the embodiment depicted in FIG. 1, the computer including the above described WJP evaluation program 34 is provided with a CPU 20 for performing various computations, a memory 13 (main storage device) that serves as a work area for the CPU 20 and the like, and an auxiliary storage device 30 such as a hard disc drive. Furthermore, as illustrated in FIG. 1, the computer may be provided with an input device 11 such as a keyboard and a mouse, a display device (output device) 12, an input-output interface 14 for the input device 11 and the display device 12, a communication interface 15 for communication with an external party via a network, and a storage/regeneration device 16 for storing and regenerating data for a disc-type storage medium M.

In the example shown in FIG. 1, the auxiliary storage device 30 pre-stores the WJP evaluation program 34 whereby a processing result of WJP on the processing target 40 can be evaluated in advance, and an operating system (OS) program 37. Specifically, the WJP evaluation apparatus 10 of the present embodiment is a computer with the WJP evaluation program 34 installed therein. In the embodiment depicted in FIG. 1, the WJP evaluation program 34 includes a flow analysis module 35 for analyzing a jet flow generated during WJP on the basis of the computational fluid dynamics (CFD), and a residual stress analysis module 36 for obtaining a processing range by WJP on the basis of the analysis result by the flow analysis module 35. The above programs 34, 37 may be loaded on the auxiliary storage device 30 from the disc-type storage medium M via the storage/regeneration device 16, or may be loaded on the auxiliary storage device 30 from an external device via the communication interface 15. The number of modules (35, 36) in the WJP evaluation program 34 is not particularly limited, and in some other embodiments, the WJP evaluation program 34 may include one or more modules.

Furthermore, the auxiliary storage device 30 may store various kinds of data to be used in the procedure of the WJP evaluation program 34. In the embodiment depicted in FIG. 1, the auxiliary storage device 30 stores a processing condition data 31 (described below) defining processing conditions for WJP, a flow analysis data 32 being a result of analysis on a jet flow that occurs during WJP processed under the various conditions constituting the processing condition data 31, and a processing range data 33 of WJP.

The CPU 20 functionally includes: a parameter receiving part 21 for receiving various parameters necessary for analysis of a jet flow by the flow analysis module 35; a condition receiving part 22 for receiving a processing condition for WJP; a flow analysis part 23 for analyzing a jet flow that occurs during WJP based on the various conditions constituting the processing condition data 31; a target-range receiving part 24 for receiving a target processing range related to a processing target; a void-fraction/collapse-fraction calculation part 25 for obtaining a void fraction f and a collapse fraction η (described below) of bubbles (cavitation bubbles) generated in the jet flow; an impact pressure correlation value calculation part 26 for obtaining a correlation value (impact pressure correlation value Pc (described below)) of the impact pressure P estimated to be applied to the surface of a processing target model 45 which is the processing target 40 modeled by bubbles generated by WJP; an experimental value acquisition part 27 for obtaining an impact pressure experimental value Pr which is an experimental value of the impact pressure P applied to the surface of the processing target 40 by WJP under the above processing condition; a prediction part 28 for obtaining an impact pressure predicted value Pp (distribution of the impact pressure predicted value Pp) which is a predicted value of the impact pressure P applied to each position on the surface of the processing target 40 by WJP under the processing condition by associating the impact pressure correlation value Pc (distribution of the impact pressure correlation value Pc) at each position on the surface of the processing target model 45 with the impact pressure experimental value Pr applied to the surface of the processing target 40 by WJP under the processing condition; and a residual stress evaluation part 29 for calculating the residual stress in the processing target 40 after WJP under the processing condition by using the impact pressure predicted value Pp obtained by the prediction part 28 as an input condition.

The above functional parts performed by the CPU 20 function in response to the CPU 20 executing the WJP evaluation program 34 loaded to the memory 13 (main storage device) from the above described auxiliary storage device 30. More specifically, in the embodiment depicted in FIG. 1, the parameter receiving part 21, the condition receiving part 22, and the flow analysis part 23 function through execution of the flow analysis module 35 of the WJP evaluation program 34. Furthermore, the target-range receiving part 24, the void-fraction/collapse-fraction calculation part 25, the impact pressure correlation value calculation part 26, the experimental value acquisition part 27, the prediction part 28, and the residual stress evaluation part 29 function through execution of the residual stress analysis module 36 of the WJP evaluation program 34.

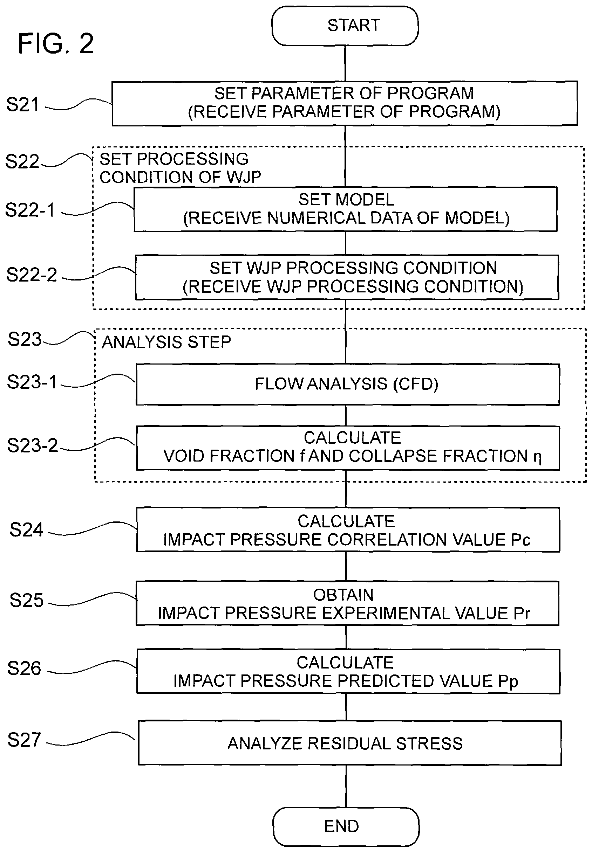

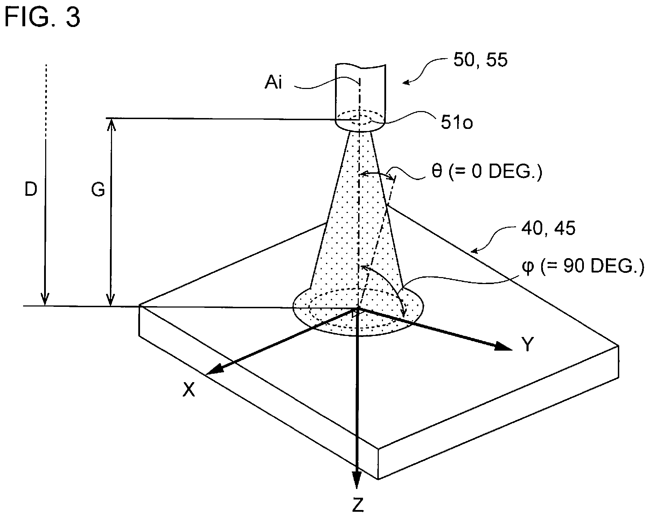

The evaluation of WJP by the WJP evaluation apparatus 10 having the above configuration is executed by the flowchart shown in FIG. 2. That is, FIG. 2 is a flowchart of a procedure of a method of evaluating WJP according to some embodiments. To simplify the description, the processing target 40 is assumed to have a flat surface as depicted in FIG. 3, and a nozzle 50 disposed on the normal (corresponding to the injection axis Ai in the example of FIG. 3) of the surface is assumed to inject a fluid containing water along the normal toward a point on the surface.

In step S21 of FIG. 2, an evaluator sets various parameters of the flow analysis module 35 by operating the input device 11 of the WJP evaluation apparatus 10. In other words, the parameter receiving part 21 of the WJP evaluation apparatus 10 receives various parameters of the flow analysis module 35 (S21: step of setting parameters of the program (parameter receiving step)). The parameter receiving part 21 of the WJP evaluation apparatus 10 receives the above parameters, and sets each parameter for a corresponding section of the flow analysis module 35 loaded on the memory 13.

In the embodiment shown in FIG. 2, the flow analysis module 35 employs a large eddy simulation (LES) model for numerically analyzing turbulence, a two-phase flow model for numerically analyzing behavior of water and a plurality of bubbles that exist in the water, and a cavitation model for numerically analyzing behavior of bubbles including generation and disappearance of bubbles. Furthermore, in the parameter setting step (S21), an evaporation coefficient, a condensation coefficient, and a bubble nucleation section volume fraction are set as the various parameters of the flow analysis module 35. Furthermore, in the parameter setting step (S21), data that depends on ambient pressure (water depth D of the processing section), density and viscosity of water, and environment (water temperature, pressure) of saturated vapor pressure is set, and the same values are set as those during the actual processing of WJP by setting a WJP processing condition (described below). Moreover, the density of vapor is set in the parameter setting step (S21), and the density of vapor when the vapor is assumed to be an ideal gas may be set.

Next, in step S22, a processing condition of WJP for the processing target 40 is set (condition setting step (condition receiving step)). For instance, by the input device 11 of the WJP evaluation apparatus 10 being operated by an evaluator, the processing condition of WJP is set in the WJP evaluation apparatus 10. In other words, the condition receiving part 22 of the WJP evaluation apparatus 10 receives the processing condition of WJP. The condition setting step (S22) includes a model setting step (step of receiving numerical data of model) (S22-1) and a WJP performing condition setting step (step of receiving WJP performing condition) (S22-2).

In the model setting step in step S22-1, the condition receiving part 22 receives a coordinate system of a space in which the processing target model 45 (see FIG. 3) being a model of the processing target 40 exists, numerical data for fixing the processing target model 45, and numerical data for fixing a nozzle model 55 (FIG. 3) being a model for the nozzle 50 which injects a fluid (e.g. water) to the processing target 40. The above information may be stored in the auxiliary storage device 30 as a part of the processing condition data 31.

In the example in FIG. 3, the above coordinate system set in the model setting step (S22-1) is a XYZ coordinate system in which origin is the intersection of the injection axis Ai of the nozzle model 55 and the surface of the processing target model 45, Z axis is a direction in which the injection axis Ai extends from the origin, X axis is an axis perpendicular to Z axis, and Y axis is an axis perpendicular to Z axis and X axis. Furthermore, in FIG. 3, a fluid is injected in a direction toward the origin along Z axis (injection axis Ai) from the nozzle model 55 disposed on Z axis (injection axis Ai). The XYZ coordinate system may have its origin at the position of the outlet 51o on the injection axis Ai at the initial position of the nozzle model 55.

Furthermore, information indicating that the surface of the processing target model 45 is a flat surface is set for the above numerical data for fixing the processing target model 45, since the surface of the processing target 40 is a flat surface in the example in FIG. 3.

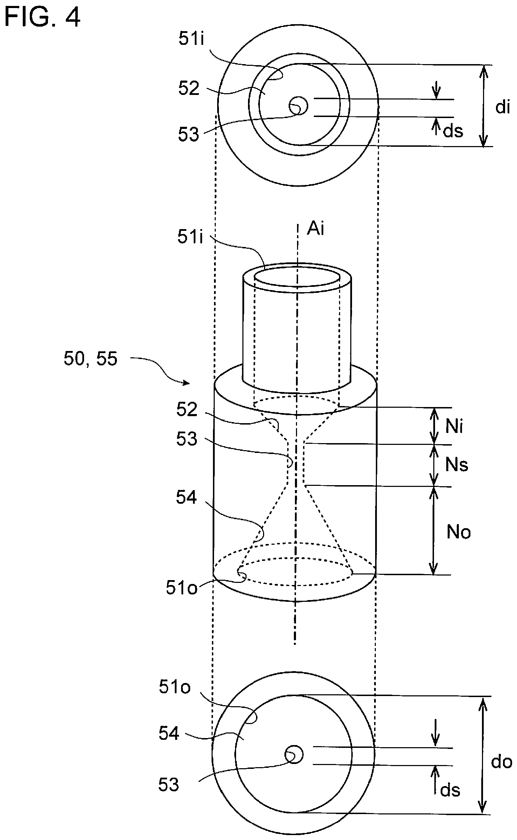

The above numerical data for fixing the nozzle model 55 is numerical data capable of expressing the nozzle 50 for injecting a fluid used in the actual processing of WJP. For instance, as depicted in FIG. 4, the actual nozzle 50 has a flow passage formed along the injection axis Ai penetrating through a cylindrical member from the first end surface to the second end surface, the opening of the flow passage on the first end surface of the nozzle 50 forming an inlet 51i, and the opening of the flow passage on the second end surface forming the outlet 51o. Further, the flow passage has a diameter reducing portion 52 at which the flow passage diameter reduces gradually toward the outlet 51o, a small diameter portion 53 at which the flow passage diameter reduced at the diameter reducing portion 52 is maintained, and a diameter increasing portion 54 at which the flow passage diameter gradually increases from the small diameter portion 53 toward the outlet.

For the nozzle 50 having the above configuration (FIG. 4), numerical data for fixing the nozzle model 55 may include the flow passage diameter di of the inlet i of the nozzle 50, the flow passage diameter ds of the small diameter portion 53, the flow passage diameter do of the outlet 51o, the length Ni of the diameter reducing portion 52 in the direction of the injection axis Ai, the length Ns of the small diameter portion 53 in the same direction, and the length No of the diameter increasing portion 54 in the same direction. While the nozzle 50 has the above described shape in the present embodiment, a nozzle model of a different shape may be used in some other embodiments, in case of which parameters that can define this other shape are set in the model setting step (S22-1).

Furthermore, in the WJP performing condition setting step in step S22-2, the condition receiving part 22 receives various conditions as WJP performing conditions so as to affect the WJP processing result. The various conditions of the WJP performing conditions include, for instance, discharge pressure of a jet flow from the nozzle 50, flow rate of a jet flow from the nozzle 50, injection distance G of a jet flow (distance from the outlet 51o of the nozzle 50 to the surface of the processing target 40) (see FIG. 3), angle θ formed by the injection axis Ai of the nozzle 50 and the surface of the processing target 40 (inclination angle of the surface of the processing target), water depth D of the surface of the processing target, water temperature, injection time t of a fluid from the nozzle 50, injection speed from the nozzle 50, flow rate, processing range S, bubble radius, nozzle angle ϕ formed by the surface of the processing target and the injection axis Ai of the nozzle 50, pitch angle which is a processing interval of WJP, etc. In the WJP processing condition setting step (S22-2), at least one of the above conditions is received. The above conditions may be stored in the auxiliary storage device 30 as a part of the processing condition data 31. In the embodiment depicted in FIG. 2, the parameters of the program set in step S21 and the WJP processing conditions set in step S22 are set separately. However, the parameters set in step S21 may be set as the various conditions of the WJP processing condition. Furthermore, analysis of a jet flow under the condition set in the condition setting step (S22) is executed in the next step S23 (S23: analysis step).

The analysis step (S23) in step S23 includes a flow analysis step (S23-1) and a calculation step of the void fraction f and the collapse fraction η (S23-2).

In the flow analysis step (S23-1), the flow analysis part 23 analyzes a jet flow under the condition set in the WJP condition setting step (S22), and obtains the number of generation and the number of disappearance of bubbles at each time at each position on the surface of the processing target model 45. The analysis result may be stored in the auxiliary storage device 30 as the flow analysis data 32. More specifically, in the flow analysis step (S23-1), in some embodiments, the number of generation and the number of disappearance of bubbles at each time at each position on the surface of the processing target model 45 are obtained as follows.

That is, analysis by CFD (e.g., unsteady large eddy simulation (LES)) is performed under the condition set in the condition setting step (S22) by using the model set in the parameter setting step (S21) (e.g. the above described two-phase flow model and the cavitation model). The analysis is normally performed until sufficient statistical information is obtained. The analysis may be performed by using a calculating function such as the analysis code FLUENT of ANSYS inc. or the like. With regard to the cavitation model, the model described in Philip J. Zwart, Andrew G. Gerber, and Thabet Belamri "*A Two-Phase Flow Model for Predicting Cavitation Dynamics"* ICMF 2004 International Conference on Multiphase Flow, Yokohama, Japan, May30-June3, 2004 Paper No. 152 may be used.

In the following step S23-2, after completion of the flow analysis step (S23-1), the void-fraction/collapse-fraction calculation part 25 calculates the void fraction f and the collapse fraction η related to bubbles at each position on the surface of the processing target model 45 (S27: step of calculating the void fraction f and the collapse fraction η).

The void fraction f is a volume fraction of bubbles contained in a unit volume of a fluid that contains water, and the collapse fraction η is a volume fraction of bubbles that burst in a unit time in a unit volume of a fluid that contains water. The void-fraction/collapse-fraction calculation part 25 uses the flow analysis data 32 stored in the auxiliary storage device 30 or the memory 13 to obtain a volume fraction of bubbles per unit time during an injection period within a unit volume of a fluid at each position on the surface of the processing target model 45. Furthermore, the void-fraction/collapse-fraction calculation part 25 uses the flow analysis data 32 stored in the auxiliary storage device 30 or the memory 13 to obtain a volume fraction of bubbles that burst in a unit time including each time within a unit volume of a fluid at each position on the surface of the processing target model 45, from the number of disappearance of the bubbles at each time in a unit volume of a fluid at each position on the surface of the processing target model 45. Further, in the embodiment depicted in FIG. 2, the void-fraction/collapse-fraction calculation part 25 calculates an average of the volume fraction per unit time as the void fraction f, and an average of the volume fraction of bubbles that burst in a unit time as the collapse fraction η. In some other embodiments, the void fraction f and the collapse fraction η are not limited to averages, and may be obtained by another statistical method.

In step S24, after completion of the analysis step (S23), the impact pressure correlation value calculation part 26 calculates the impact pressure correlation value at each position on the surface of the processing target model 45 on the basis of the void fraction f and the collapse fraction η (S24: impact pressure correlation value calculation step). Specifically, the actual impact pressure P by WJP can be expressed, from experience, by a product of the collapse fraction η of bubbles, the void fraction f of bubbles, and the coefficient k depending on the flow rate of a jet flow and the water depth D, as shown in in the following expression: P=k×η×f.

Thus, the product of the void fraction f of bubbles and the collapse fraction η of bubbles in the above expression is calculated as the impact pressure correlation value Pc. That is, the impact pressure correlation value calculation part 26 multiples the void fraction f at each position on the surface of the processing target model 45 by the collapse fraction η at the same position, and thereby obtains the impact pressure correlation value Pc at each position (distribution of the impact pressure correlation value Pc).

In step S25, the impact pressure experimental value Pr, which is an experimental value of the impact pressure P applied to the surface of the processing target 40 by WJP under the same processing conditions as those used in the analysis step (S23) is obtained (S25: experimental value acquisition step). The impact pressure experimental value Pr may be obtained by loading onto the WJP evaluation program 34 the measurement data (impact pressure experimental value Pr) of the impact pressure P obtained by performing WJP on a test piece in advance. An evaluator may input the impact pressure experimental value Pr into the WJP evaluation program 34, or the impact pressure experimental value Pr may be loaded from the auxiliary storage device 30.

Further, the prediction step (S26) is performed on the basis of data obtained in the above impact pressure correlation calculation step (S24) and the experimental value acquisition step (S25).

In the prediction step in step 26, the impact pressure correlation value Pc at each position on the surface of the processing target model 45 is associated with the impact pressure experimental value Pr applied to the surface of the processing target 40 by WJP under the same processing conditions as those used in calculation of the impact pressure correlation value Pc, and thereby the impact pressure predicted value Pp (distribution of the impact pressure predicted value Pp), which is a predicted value of the impact pressure P applied to each position on the surface of the processing target 40 by WJP under the processing condition is obtained.

More specifically, as shown in the above expression representing the experimental rule, the impact pressure P is in proportion to the impact pressure correlation value Pc, and thus the above coefficient k is obtained so as to maximize the correlation between the impact pressure P and the impact pressure correlation value Pc that can be obtained by experiment. Specifically, the impact pressure predicted value Pp is obtained by determining the coefficient k that associates the impact pressure correlation value Pc (distribution of impact pressure correlation value Pc) at each position on the surface of the processing target model 45 with the impact pressure experimental value Pr. More specifically, the position on the surface of the processing target where the impact pressure experimental value Pr is obtained, and a difference from the impact pressure correlation value Pc corresponding to the position is obtained at each position where the impact pressure experimental value Pr is obtained. Further, the coefficient k is obtained so that the above differences fall within a predetermined range.

The coefficient k may be obtained by the least-square method, for instance.

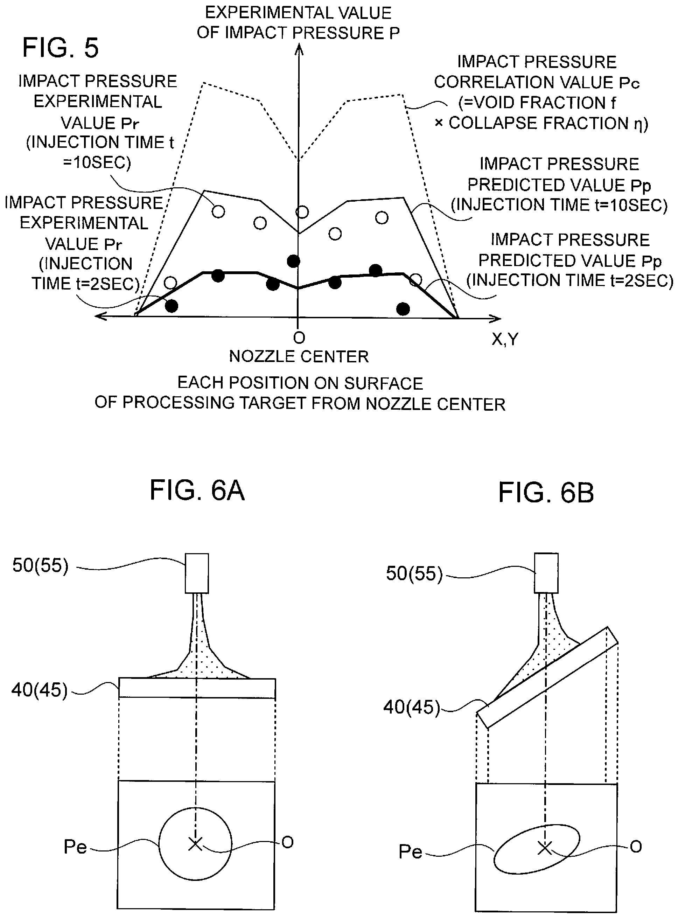

With reference to FIG. 5, a relationship between thee impact pressure correlation value Pc, the impact pressure experimental value Pr, and the impact pressure predicted value Pp will be described. In other words, FIG. 5 is a diagram for describing a relationship between the impact pressure correlation value Pc, the impact pressure experimental value Pr, and the impact pressure predicted value Pp, corresponding to FIG. 3. In FIG. 5, the center of the injection axis Ai of the nozzle 50 (nozzle center O) is an intersection of x-axis and y-axis. The position from the nozzle center O is indicated by x-axis, and the impact pressure experimental value Pr (circle) at each position is shown by y-axis. Further, FIG. 5 shows two different impact pressure experimental values Pr, for injection times t (sec) of two seconds (solid circle) and ten seconds (hollow circle). When comparing at the same position on the surface of the processing target, the impact pressure experimental value Pr is greater when the injection time is ten seconds than when the injection time is two seconds.

On the other hand, while FIG. 5 shows the above described impact pressure correlation value Pc with a dotted line, the impact pressure correlation value Pc shown in FIG. 5 is greater than the impact pressure experimental value Pr at each position. The impact pressure correlation value Pc is the void fraction f × the collapse pressure η as described above, and in other words, a solution of the above expression when the coefficient k is one. That is, when the impact pressure correlation value Pc and the impact pressure experimental value Pr are considerably different at each position, it is due to the coefficient k not being set so as to associate the impact pressure experimental value Pr with the impact pressure correlation value Pc.

Further, the impact pressure predicted value Pp is obtained by associating the two values in the above prediction step (S26), and in the example shown in FIG. 5, the impact pressure predicted value Pp represented by a thin line corresponds to the impact pressure experimental value Pr when the injection time is two seconds, while the impact pressure predicted value Pp represented by a thick line corresponds to the impact pressure experimental value Pr when the injection time is ten seconds. The two impact pressure predicted values Pp are both symmetric with respect to the nozzle center O. This is because, in FIG. 3, the normal of the processing target model 45 being a flat surface and the injection axis Ai of the nozzle model 55 are the same, for instance, and the equal pressure line Pe of the impact pressure P is distributed concentrically about the nozzle center O (see FIG. 6A). If the normal of the processing target model 45 and the nozzle model 55 do not coincide, the distribution of the impact pressure P on the surface of the processing target differs from that in FIG. 6A, and for instance, the equal pressure line Pe is distributed in an oval pattern in FIG. 6B.

In step S27, the residual stress of the processing target 40 after performing WJP under the processing condition is calculated, with an input condition being the impact pressure predicted value Pp obtained in the prediction step (S26). Specifically, by performing the FEM analysis, for instance, on the basis of the impact pressure predicted value, the residual stress is calculated (S27: residual stress analysis step).

According to the above embodiment, the generation/disappearance state of cavitation bubbles during water jet peening (WJP) is analyzed, and thereby it is possible to predict the actual impact pressure of WJP generated in the vicinity of the surface of the processing target, and to evaluate the residual stress after WJP on the basis of the predicted impact pressure.

According to some embodiments described above, the residual stress in the vicinity of the surface of the processing target 40 improved by WJP under the set processing condition is evaluated. In some other embodiments, the processing condition of WJP is determined on the basis of the evaluation result of the residual stress evaluated as described above. This is to, when the specification (e.g. size of a tube base 62 to be welded to a panel 61) of a plant is different, quickly determine a reliable WJP processing condition corresponding to the specification of each plant.

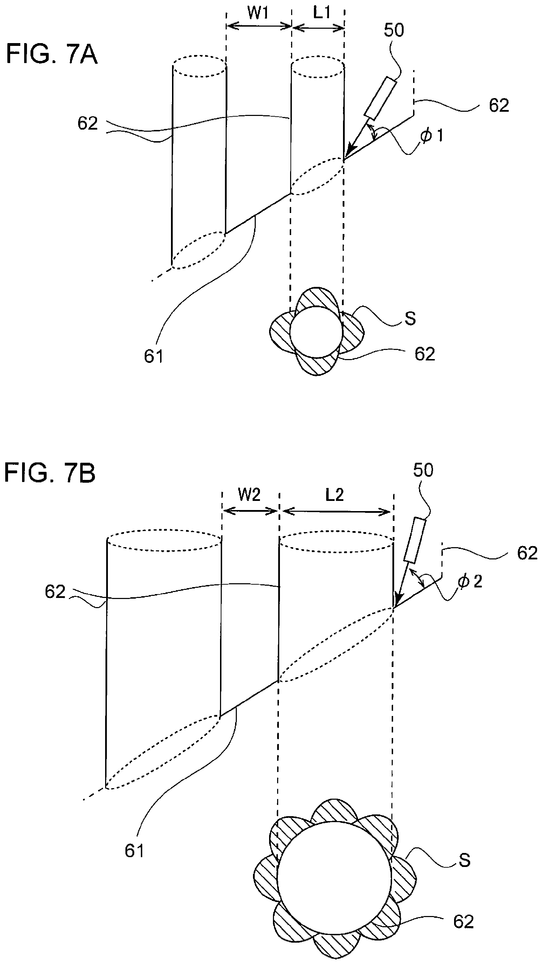

For instance, in the examples shown in FIG.s 7A and 7B, the specification of the tube base 62 which has a cylindrical shape and which is to be used in a plant is varied. Specifically, the diameter L1 of the tube base 62 shown in FIG. 7A is smaller than the diameter L2 of the tube base 62 shown in FIG. 7B. Furthermore, the distance W1 between the plurality of tube bases 62 in FIG. 7A is greater than the distance W2 between the tube bases 62 in FIG. 7B, and thus the angles ϕ formed by the nozzle 50 and the processing surface are different. Specifically, the angle ϕ1 in FIG. 7A is smaller than the angle ϕ2 in FIG. 7B (angle ϕ1<angle ϕ2). Furthermore, the size of the impact pressure P by WJP depends on the distance from the nozzle center O (see FIGs. 5 to 6B), and thus the effect to improve the residual stress by WJP depends on the size of the processing range S. Thus, to obtain a predetermined improvement effect, the processing range S is appropriately set. Further, WJP is performed at 90-degree pitch around the tube base 62 in FIG. 7A. In other words, the position of the nozzle 50 is determined at every 90 degrees around the tube base 62, and WJP is performed at each of the determined positions, so that the entire periphery of the tube base 62 is processed by WJP performed four times in total. In contrast, in FIG. 7B, the periphery of the tube base 62 is wider, and WJP is performed at 45-degree pitch around the tube base 62. If the processing conditions differ as described above, the effective range of reducing the residual stress processed in a single pitch of the nozzle 50 is also varied, which makes it necessary to increase the pitch or adjust the nozzle angle ϕ, and confirm if the target residual stress is satisfied.

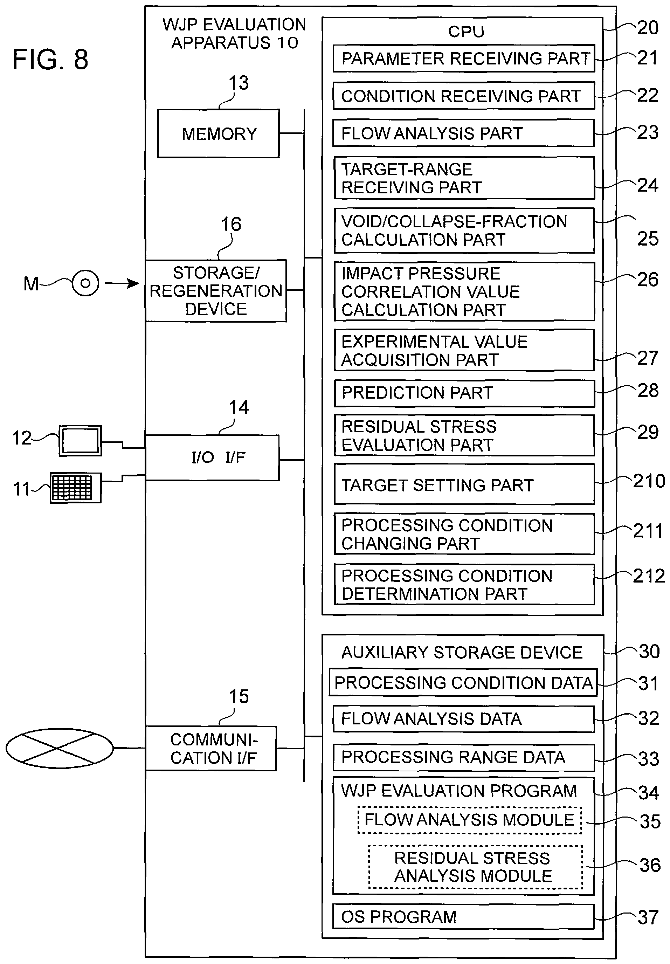

Thus, in some embodiments, as depicted in FIG. 8, in addition to the functional parts depicted in FIG. 1, the WJP evaluation apparatus 10 further includes a target value setting part 210 for setting a target value of the residual stress, a processing condition changing part 211 for changing the processing condition if the residual stress does not satisfy the target value, and a processing condition determination part 212 for determining the processing conditions used to calculate the residual stress as the processing conditions for the processing target 40 if the residual stress satisfies the target value. Furthermore, if the above functions are executed by the computer (CPU 20), any of the functional parts functions in response to the CPU 20 executing the WJP evaluation program 34 loaded to the memory 13 (main storage device) from the above described auxiliary storage device 30. More specifically, in the embodiment depicted in FIG. 8, the target value setting part 210, the processing condition changing part 211, and the processing condition determination part 212 function through execution of the flow analysis module 35 of the WJP evaluation program 34.

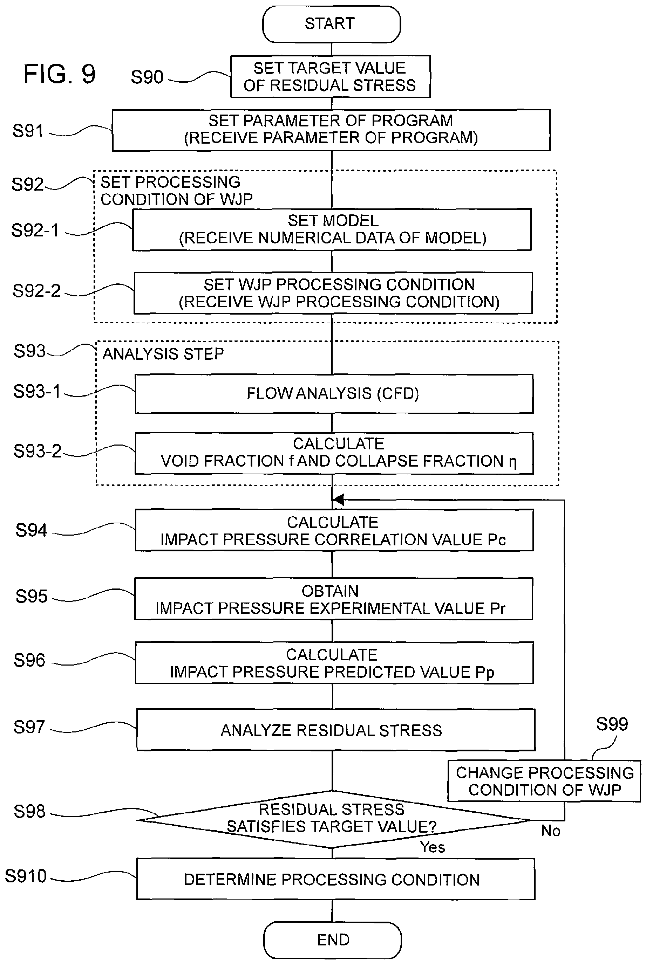

Next, with reference to the flowchart depicted in FIG. 9, the procedure of the WJP evaluation method in the present embodiment will be described.

In step S90 of FIG. 9, a target value of the residual stress is set (S90: target value setting step). The target value may be such that the residual stress becomes zero or less in the processing range S. Furthermore, for instance, the target value is set such that a target value input by an evaluator is received to be used in the WJP evaluation program 34. Then, evaluation is performed similarly to the above evaluation of the residual stress (see steps S21 to steps S27 in FIG. 2). That is, steps S91 to S97 in FIG. 9 are the same as steps S21 to S27 in FIG. 2, respectively, and thus not described in detail.

In the following step S98, the calculated residual stress and the target value (step S90) determined in advance are compared. Then, if the residual stress does not satisfy the target value, the WJP processing condition is changed in step S99 (S99: processing condition changing step). Specifically, at least one of the various conditions set in the WJP processing condition setting step (S92) is changed. For instance, the condition to be changed may be at least one of: the injection time of water jet by water jet peening; the injection speed of water jet; the flow rate of water jet; the processing range S of water jet peening; the injection distance of water jet; the radius of the bubbles; nozzle angle ϕ; or inclination angle θ of the surface of the processing target. Further, the residual stress is evaluated again (S91 to S97) on the basis of the updated WJP processing condition changed by the processing condition changing step (S99).

Furthermore, in step S98, if the calculated residual stress satisfies the target value, the processing condition used to calculate the residual stress is determined as the actual processing condition for the processing target 40 in step S910. Then the flow is ended.

If the coefficient k corresponding to the processing condition is determined in advance, the experimental value acquisition step (S95) and the prediction step (S96) are not performed, and instead, the impact pressure correlation value Pc obtained in the impact pressure correlation value calculation step (S94) and the impact pressure predicted value Pp obtained on the basis of the coefficient k may be directly used as an input condition of the residual stress analysis (S97). Furthermore, on the basis of the evaluation result of the residual stress, the specification of the WJP processing apparatus such as the function and shape of the nozzle 50 may be studied and applied to the design of a WJP processing apparatus capable of performing WJP under processing conditions that satisfy the above target value.

According to the above embodiment, even in a case where WJP is to be performed under an unproven processing condition to suit for the specification of a plant, it is possible to evaluate the residual stress after WJP through analysis, and to determine a suitable processing condition for the specification of the plant. Furthermore, WJP can be performed reliably by actually performing WJP under a processing condition determined as described above. Moreover, it is possible to make use of the analysis in design of a WJP processing apparatus for performing WJP under desired processing conditions.

In some other embodiments, in association with WJP processing conditions, related information may be used in form of a database, including residual stress, the flow analysis data 32, collapse fraction η, void fraction f, impact pressure correlation value Pc, impact pressure experimental value Pr, coefficient k, and impact pressure predicted value Pp. Accordingly, it is possible to easily obtain related information from processing conditions stored in such a database.

### Description of Reference Numerals

- 10: Evaluation apparatus
- 11: Input device
- 12: Display device
- 13: Memory
- 14: Input-output interface
- 15: Communication interface
- 16: Storage/regeneration device
- 20: CPU
- 21: Parameter receiving part
- 22: Condition receiving part
- 23: Flow analysis part
- 24: Target-range receiving part
- 25: Void-fraction/collapse-fraction calculation part
- 26: Impact pressure correlation value calculation part
- 27: Experimental value acquisition part
- 28: Prediction part
- 29: Residual stress evaluation part
- 30: Auxiliary storage device
- 31: Processing condition data
- 32: Flow analysis data
- 33: Processing range data
- 34: Evaluation program
- 35: Flow analysis module
- 36: Residual stress analysis module
- 37: OS program

- 40: Processing target
- 45: Processing target model

- 50: Nozzle
- 51i: Inlet
- 51o: Outlet
- 52: Diameter reducing portion
- 53: Small diameter portion
- 54: Diameter increasing portion
- 55: Nozzle model

- 61: Panel
- 62: Tube base

- Ai: Injection axis
- D: Water depth
- G: Injection distance
- M: Disc-type storage medium
- P: Impact pressure
- Pc: Impact pressure correlation value
- Pe: Equal pressure line
- Pp: Impact pressure predicted value
- Pr: Impact pressure experimental value

- di: Inlet flow passage diameter
- do: Outlet flow passage diameter
- ds: Flow passage diameter
- f: Void fraction
- k: Coefficient
- t: Injection time
- O: Nozzle center
- L1: Tube base diameter
- L2: Tube base diameter
- W1: Distance between tube bases
- W2: Distance between tube bases
- S: Processing range
- ϕ: Nozzle angle

## Claims

1. A method of evaluating a residual stress, comprising:
a condition setting step (S21, S91) of setting a processing condition of water jet peening for a processing target (40);
a flow analysis step (S23, S93) of numerically analyzing, using computational fluid dynamics, a jet flow when a fluid is injected from a nozzle model (55) to a processing target model (45) in accordance with the processing condition, and obtaining a void fraction (f) which is a volume fraction of bubbles contained in a unit volume of the fluid, and a collapse fraction (η), which is a volume fraction of the bubbles which collapse in a unit time in the unit volume of the fluid, at each position on a surface of the processing target model;
an impact pressure correlation value calculating step (S24, S94) of obtaining, at each position on the surface of the processing target model, an impact pressure correlation value (Pc), which is a product of the void fraction and the collapse fraction at each position;
an experimental value acquisition step (S25, S95) of obtaining, at multiple positions of the surface of the processing target model, an impact pressure experimental value (Pr), which is an experimental value of an impact pressure applied to a surface of the processing target due to the water jet peening under the processing condition;
a prediction step (S26, S96) of obtaining an impact pressure predicted value (Pp), which is a predicted value of the impact pressure applied to each position on the surface of the processing target due to the water jet peening under the processing condition, by determining a coefficient k for associating the impact pressure correlation value (Pc) at each position on the surface of the processing target model with the impact pressure experimental value (Pr) applied to the surface of the processing target by the water jet peening under the processing condition , wherein the coefficient k is obtained so that the difference between the position on the surface of the processing target where the impact pressure experimental value Pr is obtained and the impact pressure correlation value Pc corresponding to that position fall within a predetermined range, wherein the impact pressure predicted value (Pp) is equal to the coefficient k times the impact pressure correlation value (Pc); and
a residual-stress evaluation step (S27, S97) of calculating, by performing a finite element method analysis, a residual stress of the processing target after the water jet peening under the processing condition by using the impact pressure predicted value obtained in the prediction step as an input condition.

2. The method of evaluating a residual stress according to claim 1, further comprising:
a target setting step (S90) of setting a target value of the residual stress;
a processing-condition changing step (S99) of changing the processing condition if the residual stress does not satisfy the target value;
a re-evaluation step (S98) of executing the analysis step, the impact pressure correlation value calculation step, and the residual-stress evaluation step under a changed processing condition changed in the processing-condition changing step; and
a processing-condition determination step (S910) of determining the processing condition used in the re-evaluation step as the processing condition for the processing target, if the residual stress calculated in the re-evaluation step satisfies the target value.

3. The method of evaluating a residual stress according to claim 2,
wherein, if the residual stress calculated in the re-evaluation step (S98) does not satisfy the target value, the processing condition is further changed in the processing-condition changing step (S99), and the re-evaluation step (S98) is performed under the changed processing condition further changed in the processing-condition changing step.

4. The method of evaluating a residual stress according to any one of claims 1 to 3,
wherein the processing condition includes at least one of: an injection time (t) of water jet by the water jet peening; an injection speed of the water jet, a flow rate of the water jet, a processing range (S) of the water jet peening, an injection distance (G) of the water jet, a radius of the bubbles, a nozzle angle (ϕ), or an inclination angle of the surface of the processing target (40).

5. A computer program comprising instructions which, when the program is executed by a computer, causes the computer to carry out the method according to any one of the claims 1 to 4.

6. An evaluation apparatus (10) for water jet peening, comprising a central processing unit configured to perform the method of any one of claims 1 to 4.

## Patentansprüche

1. Verfahren zur Restspannungsbeurteilung, umfassend:
einen Bedingungseinstellungsschritt (S21, S91), wobei eine Verarbeitungsbedingung des Wasserstrahlhämmerns für ein Verarbeitungsziel (40) eingestellt wird;
einen Flussanalyseschritt (S23, S93), wobei unter Verwendung von computerunterstützter Fluiddynamik ein Strahlfluss numerisch analysiert wird, wenn ein Fluid aus einem Düsenmodell (55) auf ein Verarbeitungszielmodell (45) gemäß der Verarbeitungsbedingung eingespritzt wird, und einen Lückenanteil (f), bei dem es sich um einen Volumenanteil von Blasen handelt, die in einer Volumeinheit des Fluids enthalten sind, und einen Kollabieranteil (n), bei dem es sich um einen Volumenanteil der Blasen handelt, die in einer Zeiteinheit in der Volumeneinheit des Fluids an jeder Position auf einer Oberfläche des Verarbeitungszielmodells kollabieren, erzielt wird;
einen Schritt (S24, S94) zum Berechnen eines Aufschlagdruckkorrelationswertes, wobei an jeder Position auf der Oberfläche des Verarbeitungszielmodells ein Aufschlagdrucckorrelationswert (Pc) erzielt wird, bei dem es sich um ein Produkt des Lückenanteils und des Kollabieranteils an jeder Position handelt;
einen Schritt (S25, S95) zum Erfassen eines experimentellen Wertes, wobei an mehreren Positionen der Oberfläche des Verarbeitungszielmodells ein experimenteller Aufschlagdruckwert (Pr) erzielt wird, bei dem es sich um einen experimentellen Wert eines Aufschlagdrucks handelt, der auf eine Oberfläche des Verarbeitungsziels auf Grund des Wasserstrahlhämmerns unter der Verarbeitungsbedingung ausgeübt wird;
einen Vorhersageschritt (S26, S96), wobei ein vorhergesagter Aufschlagdruckwert (Pp) erzielt wird, bei dem es sich um einen vorhergesagten Wert des Aufschlagdrucks handelt, der auf jede Position auf der Oberfläche des Verarbeitungsziels auf Grund des Wasserstrahlhämmerns unter der Verarbeitungsbedingung ausgeübt wird, indem ein Koeffizient k zum Zuordnen des Aufschlagdrucckorrelationswertes (Pc) an jeder Position auf der Oberfläche des Verarbeitungszielmodells zu dem experimentellen Aufschlagdruckwert (Pr), der auf die Oberfläche des Verarbeitungsziels durch das Wasserstrahlhämmern unter der Verarbeitungsbedingung ausgeübt wird, bestimmt wird, wobei der Koeffizient k derart erzielt wird, dass die Differenz zwischen der Position auf der Oberfläche des Verarbeitungsziels, an welcher der experimentelle Aufschlagdruckwert Pr erzielt wird, und dem Aufschlagdruckkorrelationswert Pc, der dieser Position entspricht, in einen vorbestimmten Bereich fällt,
wobei der vorhergesagte Aufschlagdruckwert (Pp) gleich dem Koeffizienten k-mal der Aufschlagdruckkorrelationswert (Pc) ist; und
einen Restspannungsbeurteilungsschritt (S27, S97), wobei durch das Ausführen einer Analyse nach der Finite-Elemente-Methode, eine Restspannung des Verarbeitungsziels nach dem Wasserstrahlhämmern unter der Verarbeitungsbedingung unter Verwendung des vorhergesagten Aufschlagdruckwertes, der in dem Vorhersageschritt als Eingabebedingung erzielt wird, berechnet wird.

2. Verfahren zur Restspannungsbeurteilung nach Anspruch 1, ferner umfassend:
einen Zieleinstellungsschritt (S90), wobei ein Zielwert der Restspannung eingestellt wird;
einen Schritt (S99) zum Ändern einer Verarbeitungsbedingung, wobei die Verarbeitungsbedingung geändert wird, falls die Restspannung den Zielwert nicht erfüllt;
einen Wiederbeurteilungsschritt (S98), wobei der Analyseschritt, der Schritt zum Berechnen eines Aufschlagdruckkorrelationswertes und der Restspannungsbeurteilungsschritt unter einer geänderten Verarbeitungsbedingung, die in dem Schritt zum Ändern einer Verarbeitungsbedingung geändert wird, ausgeführt werden; und
einen Schritt (S910) zum Bestimmen einer Verarbeitungsbedingung, wobei die Verarbeitungsbedingung, die in dem Wiederbeurteilungsschritt verwendet wird, als die Verarbeitungsbedingung für das Verarbeitungsziel bestimmt wird, falls die Restspannung, die in dem Wiederbeurteilungsschritt berechnet wird, den Zielwert erfüllt.

3. Verfahren zur Restspannungsbeurteilung nach Anspruch 2, wobei, falls die Restspannung, die in dem Wiederbeurteilungsschritt (S98) berechnet wird, den Zielwert nicht erfüllt, die Verarbeitungsbedingung ferner in dem Schritt (S99) zum Ändern einer Verarbeitungsbedingung geändert wird, und der Wiederbeurteilungsschritt (S98) unter der geänderten Verarbeitungsbedingung ausgeführt wird, die ferner in dem Schritt zum Ändern einer Verarbeitungsbedingung geändert wird.

4. Verfahren zur Restspannungsbeurteilung nach einem der Ansprüche 1 bis 3,
wobei die Verarbeitungsbedingung mindestens eines umfasst von: einer Injektionszeit (t) des Wasserstrahls durch das Wasserstrahlhämmern; einer Injektionsgeschwindigkeit des Wasserstrahls, einer Fließgeschwindigkeit des Wasserstrahls, einem Verarbeitungsbereich (S) des Wasserstrahlhämmerns, einer Einspritzdistanz (G) des Wasserstrahls, einen Radius der Blasen, einem Düsenwinkel (ϕ) oder einem Neigungswinkel der Oberfläche des Verarbeitungsziels (40).

5. Computerprogramm, das Anweisungen umfasst, die, wenn das Programm von einem Computer ausgeführt wird, bewirken, dass der Computer das Verfahren nach einem der Ansprüche 1 bis 4 ausführt.

6. Beurteilungsgerät (10) zum Wasserstrahlhämmern, umfassend eine Zentraleinheit, die dazu konfiguriert ist, das Verfahren nach einem der Ansprüche 1 bis 4 auszuführen.

## Revendications

1. Procédé d'évaluation d'une contrainte résiduelle, comprenant :
une étape de réglage de condition (S21, S91) dans laquelle on règle une condition de traitement de martelage au jet d'eau pour une cible de traitement (40) ;
une étape d'analyse d'écoulement (S23, S93) dans laquelle on analyse numériquement, à l'aide de la mécanique des fluides numérique, un écoulement dans une tuyère lorsqu'un fluide est injecté d'un modèle de buse (55) à une modèle de cible de traitement (45) en conformité avec la condition de traitement, et on obtient une fraction de vide (f) qui est une fraction volumique de bulles contenues dans une unité de volume du fluide et une fraction d'effondrement (η), qui est une fraction volumique des bulles qui s'effondrent dans une unité de temps dans l'unité de volume du fluide, à chaque position sur une surface du modèle de cible de traitement ;
une étape de calcul de valeur de corrélation de pression d'impact (S24, S94) dans laquelle on obtient, à chaque position sur la surface du modèle de cible de traitement, une valeur de corrélation de pression d'impact (Pc), qui est un produit de la fraction de vide et de la fraction d'effondrement à chaque position ;
une étape d'acquisition de valeur expérimentale (S25, S95) dans laquelle on obtient, dans plusieurs positions de la surface du modèle de cible de traitement, une valeur expérimentale de pression d'impact (Pr) qui est une valeur expérimentale d'une pression d'impact appliquée sur une surface de la cible de traitement due au martelage au jet d'eau dans la condition de traitement ;
une étape de prévision (S26, S96) dans laquelle on obtient une valeur prévue de pression d'impact (Pp), qui est une valeur prévue de la pression d'impact appliquée à chaque position sur la surface de la cible de traitement due au martelage au jet d'eau dans la condition de traitement, en déterminant un coefficient k pour associer la valeur de corrélation de pression d'impact (Pc) dans chaque position sur la surface du modèle de cible de traitement avec la valeur expérimentale de pression d'impact (Pr) appliquée sur la surface de la cible de traitement par le martelage au jet d'eau dans la condition de traitement, dans lequel le coefficient k est obtenu de sorte que la différence entre la position sur la surface de la cible de traitement où la valeur expérimentale de pression d'impact Pr est obtenue et la valeur de corrélation de pression d'impact Pc correspondant à cette position tombent dans une plage prédéterminée,
dans lequel la valeur prévue de pression d'impact (Pp) est égale au coefficient k multiplié par la valeur de corrélation de pression d'impact (Pc) ; et
une étape d'évaluation de contrainte résiduelle (S27, S97) dans laquelle on calcule, en réalisant une analyse par méthode des éléments finis, une contrainte résiduelle de la cible de traitement après le martelage au jet d'eau dans la condition de traitement en utilisant la valeur prévue de pression d'impact obtenue à l'étape de prévision en tant que condition d'entrée.

2. Procédé d'évaluation d'une contrainte résiduelle selon la revendication 1, comprenant en outre :
une étape de définition de cible (S90) dans laquelle on définit une valeur cible de la contrainte résiduelle ;
une étape de changement de condition de traitement (S99) dans laquelle on modifie la condition de traitement si la contrainte résiduelle ne satisfait pas la valeur cible ;
une étape de réévaluation (S98) dans laquelle on exécute l'étape d'analyse, l'étape de calcul de valeur de corrélation de pression d'impact, et l'étape d'évaluation de contrainte résiduelle dans une condition de traitement modifiée, modifiée à l'étape de changement de condition de traitement ; et
une étape de détermination de condition de traitement (S910) dans laquelle on détermine la condition de traitement utilisée à l'étape de réévaluation en tant que condition de traitement pour la cible de traitement, si la contrainte résiduelle calculée à l'étape de réévaluation satisfait la valeur cible.

3. Procédé d'évaluation d'une contrainte résiduelle selon la revendication 2,
dans lequel, si la contrainte résiduelle calculée à l'étape de réévaluation (S98) ne satisfait pas la valeur cible, la condition de traitement est à nouveau modifiée à l'étape de changement de condition de traitement (S99), et l'étape de réévaluation (S98) est réalisée dans la condition de traitement modifiée à nouveau modifiée à l'étape de changement de condition de traitement.

4. Procédé d'évaluation d'une contrainte résiduelle selon l'une quelconque des revendications 1 à 3,
dans lequel la condition de traitement comprend au moins l'un parmi : un temps d'injection (t) de jet d'eau par le martelage au jet d'eau ; une vitesse d'injection du jet d'eau, un débit du jet d'eau, une plage de traitement (S) du martelage au jet d'eau, une distance d'injection (G) du jet d'eau, un rayon des bulles, un angle de buse (ϕ) ou un angle d'inclinaison de la surface de la cible de traitement (40).

5. Programme informatique comprenant des instructions qui, lorsque le programme est exécuté par un ordinateur, amènent l'ordinateur à réaliser le procédé selon l'une quelconque des revendications 1 à 4.

6. Appareil d'évaluation (10) pour martelage au jet d'eau, comprenant une unité de traitement centrale configurée pour réaliser le procédé selon l'une quelconque des revendications 1 à 4.
